# EUROPEAN PATENT SPECIFICATION

(11) **EP 1 338 037 B1**
(45) Date of publication and mention of the grant of the patent: **30.03.2011**
(21) Application number: 01999006.8
(22) Date of filing: 15.11.2001
(51) Int. Cl.: H01L 27/115

(54) **Non-volatile SONOS semiconductor memory device**
Nicht-flüchtiges SONOS-Halbleiterspeicherbauelement
Dispositif de mémoire non-volatile SONOS à semi-conducteur

(30) Priority: 28.11.2000 US 723635; 27.06.2001 US 893026
(43) Date of publication of application: 27.08.2003
(73) Proprietor: Spansion LLC, Sunnyvale, CA 94088-3453 (US)
(72) Inventor: RAMSBEY, Mark, T., Sunnyvale, CA 94087 (US); YANG, Jean, Y., Sunnyvale, CA 94087 (US); SHIRAIWA, Hidehiko, San Jose, CA 95120 (US); VAN BUSKIRK, Michael, A., Saratoga, CA 95070 (US); ROGERS, David, M., Sunnyvale, CA 94087 (US); SUNKAVALLI, Ravi, Milpitas, CA 95035 (US); WANG, Janet, San Francisco, CA 94109 (US); DERHACOBIAN, Narbeh, Belmont, CA 94002 (US); WU, Yider, San Jose, CA 95131 (US)
(74) Representative: Wright, Hugh Ronald
(86) International application number: PCT/US2001/046124
(87) International publication number: WO 2002/045171

(56) References cited:
- US-A- 5 168 334
- US-A- 5 751 037
- US-A- 6 117 730
- PATENT ABSTRACTS OF JAPAN vol. 1995, no. 01, 28 February 1995 (1995-02-28) & JP 06 291330 A (CITIZEN WATCH CO LTD), 18 October 1994 (1994-10-18)

## Description

### TECHNICAL FIELD

The present invention generally relates to nonvolatile memory devices. In particular, the present invention relates to SONOS type non-volatile memory devices having a substantially planar structure.

### BACKGROUND ART

Conventional floating gate flash memory types of EEPROMs (electrically erasable programmable read only memory), employ a memory cell characterized by a vertical stack of a tunnel oxide, a first polysilicon layer over the tunnel oxide, an ONO (oxide-nitride-oxide) interlevel dielectric over the first polysilicon layer, and a second polysilicon layer over the ONO interlevel dielectric. For example, Guterman et al (IEEE Transactions on Electron Devices, Vol. 26, No. 4, p. 576,1979) relates to a floating gate nonvolatile memory cell consisting of a floating gate sandwiched between a gate oxide and an interlevel oxide, with a control gate over the interlevel oxide.

Subsequently, SONOS (Silicon Oxide Nitride Oxide Silicon) type memory devices have been introduced. See Chan et al, IEEE Electron Device Letters, Vol. 8, No. 3, p. 93, 1987. SONOS type flash memory cells are constructed having a charge trapping non-conducting dielectric layer, typically a silicon nitride layer, sandwiched between two silicon dioxide layers (insulating layers). The nonconducting dielectric layer functions as an electrical charge trapping medium. A conducting gate layer is placed over the upper silicon dioxide layer. Since the electrical charge is trapped locally near whichever side that is used as the drain, this structure can be described as a two-transistor cell, or two-bits per cell. If multi-level is used, then four or more bits per cell can be accomplished. Multi-bit cells enable SONOS type memory devices to have the advantage over others in facilitating the continuing trend increasing the amount of information held/processed on an integrated circuit chip.

SONOS type memory devices offer additional advantages. In particular, the erase mechanism of the memory cell is greatly enhanced. Both bits of the memory cell can be erased by applying suitable erase voltages to the gate and the drain for the right bit and to the gate and the source for the left bit. Another advantage includes reduced wearout from cycling thus increasing device longevity. An effect of reading in the reverse direction is that a much higher threshold voltage for the same amount of programming is possible. Thus, to achieve a sufficient delta in the threshold voltage between the programmed and unprogrammed states of the memory cell, a much smaller region of trapped charge is required when the cell is read in the reverse direction than when the cell is read in the forward direction.

Although many advantages are described above, there are at least two disadvantages associated with SONOS type memory devices. One disadvantage is that isolation by LOCOS (LOCal Oxidation of Silicon) takes up a relatively large amount of space. Given the continuing trend towards miniaturization and increased integration of devices on an integrated circuit chip, efficient utilization of space is of increasing importance. Isolation by LOCOS also causes undesirable outgassing of dopants.

Another disadvantage with SONOS type memory devices is that LOCOS formation causes short channeling. There are high temperatures associated with LOCOS formation, often from 800 C to 1,100 C. Short channeling is a decrease in the effective channel length, often represented as L_{eff}. Unnecessarily decreasing the effective channel length results in an undesirably large current passing through the transistor at low gate voltages such as when the transistor is in the 'off' state.

Thermal cycling associated with LOCOS formation also causes an increase in bitline to bitline punch-through leakage. That is, diffusion caused by thermal cycling leads to undesirable leakage between bitlines.

US 6,117,730 discloses a process for fabricating an ONO structure for a MONOS type flash cell having a core and a periphery in which seeks to maintain a high quality device despite processing steps.

US 5,168,334 discloses a small-area single-transistor EEPROM memory cell with ONO layer in which electrical contact is made to word lines and bitlines by metal contacts at the array periphery, avoiding metal contacts to every memory cell in the array.

US 5,751,037 discloses a non-volatile memory device with gate electrodes formed on an upper and lower surface of a channel via insulating layers, used as read and write electrodes, respectively, without exerting influence, one on another.

### SUMMARY OF THE INVENTION

The present invention provides non-volatile semiconductor memory devices having a substantially planar structure. The SONOS type nonvolatile memory devices lead to the efficient production of dense, robust single-poly devices, having a substantially planar structure. Compared to conventional SONOS memory devices , the present invention provides a substantially planar structure and eliminates the need for a core region etch step thus reducing costs and defect formation. There are a number of benefits associated with the generally flat topography of the memory devices. The present invention eliminates high temperature thermal cycling associated with LOCOS formation in the core region, thereby minimizing and/or eliminating short channeling. The present invention also eliminates undesirable bird's beak associated with LOCOS formation which may lead to fewer defects and/or improved scaling. Another advantage is that in some instances the bitline implant does not experience the periphery gate oxide thermal cycle.

### BRIEF DESCRIPTION OF DRAWINGS

Figure 1 illustrates a cross-sectional view of one aspect of a method.
Figure 2 illustrates a cross-sectional view of another aspect of a method.
Figure 3 illustrates a cross-sectional view of yet another aspect of a method.
Figure 4 illustrates a cross-sectional view of still yet another aspect of a method.
Figure 5 illustrates a cross-sectional view of another aspect of a method.
Figure 6 illustrates a cross-sectional view of a SONOS type memory cell in accordance with one aspect of the invention.
Figure 7 illustrates a cross-sectional view of one aspect of another method.
Figure 8 illustrates a cross-sectional view of another aspect of another method.
Figure 9 illustrates a cross-sectional view of yet another aspect of another method.
Figure 10 illustrates a cross-sectional view of still yet another aspect of another method.
Figure 11 illustrates a cross-sectional view of another aspect of another method.
Figure 12 illustrates a cross-sectional view of a SONOS type memory cell in accordance with another aspect of the invention.
Figure 13 illustrates a cmss-sectional view of one aspect of yet another method.
Figure 14 illustrates a cross-sectional view of another aspect of yet another method.
Figure 15 illustrates a cross-sectional view of yet another aspect of yet another method.
Figure 16 illustrates a cross-sectional view of still yet another aspect of yet another method.
Figure 17 illustrates a cross-sectional view of another aspect of yet another method.
Figure 18 illustrates a cross-sectional view of another aspect of yet another method.
Figure 19 illustrates a cross-sectional view of a SONOS type memory cell in accordance with yet another aspect of the invention.
Figure 20 illustrates a perspective view of the core region of a SONOS type memory device in accordance with one aspect of the invention.
Figure 21 illustrates a perspective view of the core region of another SONOS type memory device in accordance with one aspect of the invention.
Figure 22 illustrates a perspective view of the core region of a prior art SONOS type memory device.

### DISCLOSURE OF INVENTION

The present invention involves a substantially planar SONOS type nonvolatile memory devices. The SONOS type memory cells of an array are coupled to wordlines and bitlines. In particular, the drains and the sources of the SONOS type memory cells are connected to the bitlines. Using peripheral decoders and control circuitry, each memory cell can be addressed for programming, reading or erasing functions. Formation of bitlines is therefore necessary to the operation of the SONOS type nonvolatile memory devices.

Non-volatile semiconductor memory device according to the invention contain a substrate, a charge trapping dielectric over the core region of the substrate, a gate dielectric in the periphery region of the substrate, buried bitlines under the charge trapping dielectric in the core region, and wordlines over the charge trapping dielectric in the core region, wherein the core region is substantially planar.

One aspect of the present invention involves providing substantially planar non-volatile semiconductor memory devices that do not contain LOCOS in the core region. As a result, undesirable bird's beak and high temperature thermal cycling associated with LOCOS formation is minimized and/or eliminated. The planar structure of the core permits the reliable formation of additional layers and structures thereover that are necessary to complete the fabrication of the non volatile semiconductor memory devices. Handling and packaging non-volatile semiconductor memory devices having substantially planar core regions is typically easier and more efficient than memory devices that do not have planar core regions. The less severe topography of the non-volatile semiconductor memory devices of the present invention contributes to improved linewidth control (more uniform linewidths) as well as improved junctions (controlled diffusion).

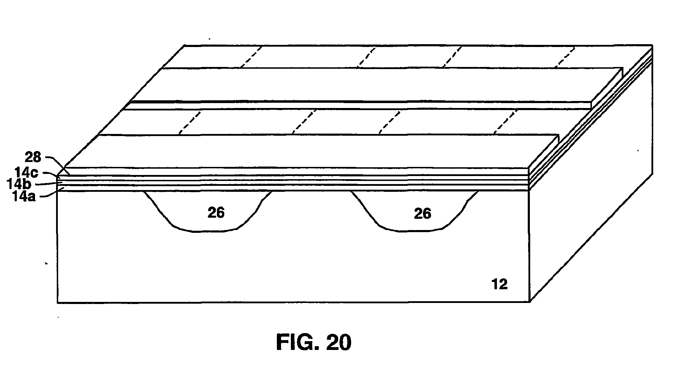

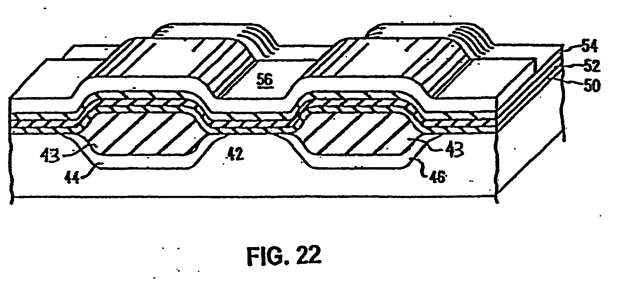

Substantially planar does not require absolute planarity. Substantially planar means the absence of severe variations in surface height. In a substantially planar surface, there may exist mesas, peaks, and valleys that do not vary (from the top of a peak to the bottom of a valley) by more than about 250Å. In another embodiment, a substantially planar surface, there may exist mesas, peaks, and valleys that do not vary by more than about 200Å. In yet another embodiment, a substantially planar surface, there may exist mesas, peaks, and valleys that do not vary by more than about 100Å. Substantially planar may alternatively mean that the wordlines are substantially uniform in thickness across the core region and simultaneously generally planar. For example, the structure of Figure 20 is substantially planar (although it is not absolutely planar) whereas the structure of Figure 22 is not substantially planar.

Generally speaking, a method of forming a substantially planar non-volatile semiconductor memory device involves sequentially or non-sequentially forming a charge trapping dielectric over a substrate; removing at least a portion of the charge trapping dielectric in the periphery region; forming a gate dielectric in the periphery region; forming buried bitlines in the core region; and forming gates in the core region and the periphery region.

Another method of forming a substantially planar non-volatile semiconductor memory device involves forming a charge trapping dielectric over a substrate; removing at least a portion of the charge trapping dielectric in the periphery region; forming a gate dielectric in the periphery region; forming buried bitlines in the core region; and forming gates in the core region and the periphery region.

Yet another method of forming a substantially planar non-volatile semiconductor memory device involves forming a charge trapping dielectric over a substrate; forming buried bitlines in the core region; removing at least a portion of the charge trapping dielectric in the periphery region; forming a gate dielectric in the periphery region; and forming gates in the core region and the periphery region.

Still yet another method of forming a substantially planar non-volatile semiconductor memory device involves forming a charge trapping dielectric over a substrate; removing at least a portion of the charge trapping dielectric in the periphery region; forming a gate dielectric having a first thickness in the periphery region; forming buried bitlines in the core region; increasing the thickness of the gate dielectric in at least a portion of the periphery region to provide a gate dielectric having a second thickness; and forming gates in the core region and the periphery region.

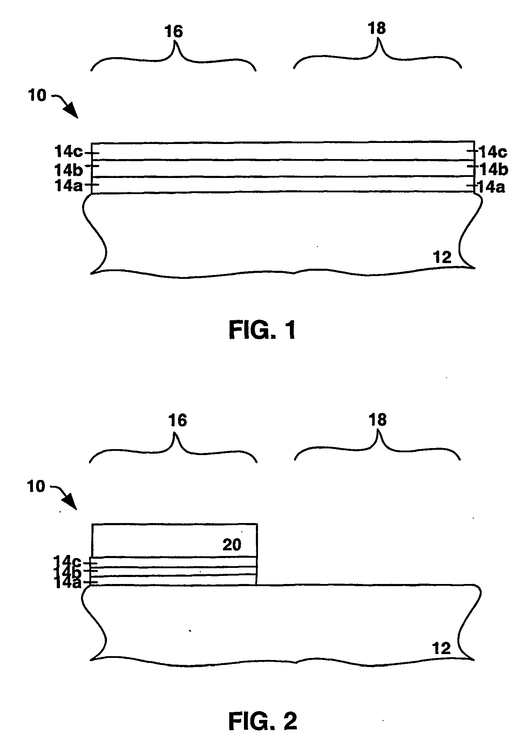

The present invention is now described with reference to the figures, wherein like features are referred to with like numbers throughout. One aspect of the present invention is described in Figures 1-6. Referring to Figure 1, a semiconductor structure 10 is shown with a semiconductor substrate 12 under a charge trapping dielectric 14. Semiconductor structure 10 contains two regions, the core region 16 containing the memory cells and the periphery region 18 containing the rest of the chip such as the controlling logic and input/output devices. As shown the charge trapping dielectric 14 contains three layers; namely, a first silicon dioxide layer 14a, a silicon nitride layer 14b, and a second silicon dioxide layer 14c (an ONO dielectric). Particularly in the case of an ONO dielectric, the electron trapping is in the silicon nitride layer 14b.

The charge trapping dielectric 14, may be any dielectric layer or layers that are capable of or facilitate electron trapping. For example, charge trapping dielectrics include an ONO trilayer dielectric, an oxide/nitride bilayer dielectric, a nitride/oxide bilayer dielectric, an oxide/tantalum oxide bilayer dielectric (SiO₂/Ta₂O₅), an oxide/tantalum oxide/oxide trilayer dielectric (SiO₂/Ta₂O₅ /SiO₂), an oxide/strontium titanate bilayer dielectric (SiO₂/SrTO₃), an oxide/barium strontium titanate bilayer dielectric (SiO₂/BaSrTiO₂), an oxide/strontium titanate/oxide trilayer dielectric (SiO₂SrTiO_{3/}SiO₂), an oxide/strontium titanate/barium strontium titanate trilayer dielectric (SiO₂/SrTiO₃/BaSrTiO₂), an oxide/hafnium oxide/oxide trilayer dielectric, and the like (in each case, the first layer mentioned is the bottom layer while the last layer mentioned is the top layer). Although the term SONOS type nonvolatile memory device is often used herein, it is to be understood that a SONOS type nonvolatile memory device as used herein may contain any of the charge trapping dielectrics described above. In other words, a SONOS type nonvolatile memory device contains any dielectric layer or layers that are capable of or facilitate electron trapping, and the SONOS type nonvolatile memory device contains an ONO charge trapping dielectric only when a specific reference to such dielectric is indicated.

Moreover, in the embodiments where the charge trapping dielectric is an ONO dielectric, one or both of the silicon dioxide layers 14a and 14c may be a silicon-rich silicon dioxide layer. One or both of the silicon dioxide layers 14a and 14c may also be an oxygen-rich silicon dioxide layer. One or both of the silicon dioxide layers 14a and 14c may be a thermally grown or a deposited oxide. One or both of the silicon dioxide layers 14a and 14c may be nitrided oxide layers. The nitride 14b may be a silicon-rich silicon nitride layer. The nitride 14b may also be an nitrogen-rich silicon nitride layer. In one embodiment, the charge trapping dielectric 14 has a thickness from about 75Å to about 300Å. In another embodiment, the charge trapping dielectric 14 has a thickness from about 100Å to about 275Å. In yet another embodiment, the charge trapping dielectric 14 has a thickness from about 110Å to about 250Å.

In this connection, in one embodiment, the oxide layers 14a and 14c individually have thicknesses from about 50Å to about 150Å while the nitride layer 14b has a thickness from about 20Å to about 80Å. In another embodiment, the oxide layers 14a and 14c individually have thicknesses from about 60Å to about 140Å while the nitride layer 14b has a thickness from about 25Å to about 75Å. In yet another embodiment, the oxide layers 14a and 14c individually have thicknesses from about 70Å to about 130Å while the nitride layer 14b has a thickness from about 30Å to about 70Å.

Although not shown, a threshold implant (V_{T} adjustment implant) step may be conducted before formation of the charge trapping dielectric 14 over the structure. For example, a blanket implantation of boron may be performed just prior to forming the charge trapping dielectric 14. As explained below, this implantation step may be conducted before or after the bitline implantation step.

Referring to Figure 2, a mask such as a suitable photoresist 20 is used to cover the charge trapping dielectric 14 in the core region 16 leaving the charge trapping dielectric 14 exposed in the periphery region 18 of the structure 10. The charge trapping dielectric 14 exposed in the periphery region 18 is etched down to the substrate 12 (the first silicon dioxide layer 14a, the silicon nitride layer 14b, and the second silicon dioxide layer 14c are removed in the periphery region 18 of the structure 10). Multiple etching steps may be employed to remove the charge trapping dielectric 14.

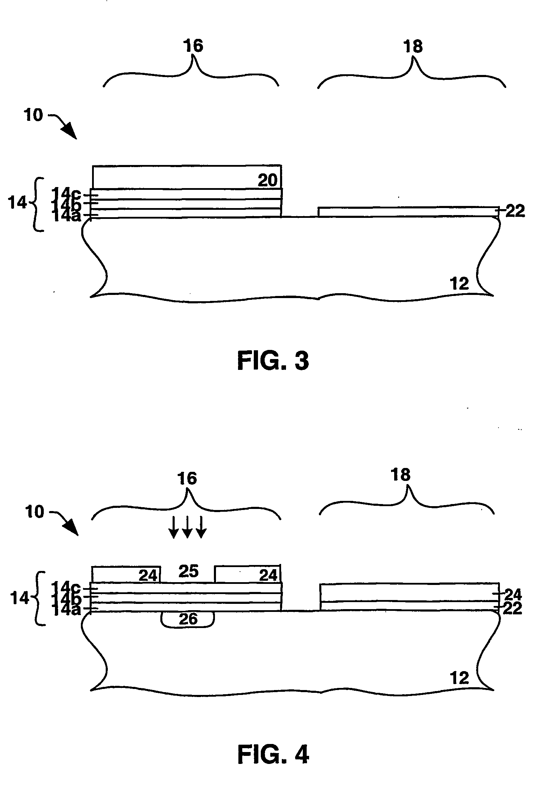

Referring to Figure 3, a gate dielectric 22 such as an oxide layer is provided using any suitable means, such as chemical vapor deposition (CVD), dry oxidation, wet oxidation or rapid thermal oxidation, on at least a portion of the exposed portions of the substrate 12 (over the periphery region its). Dry oxidation, wet oxidation, and rapid thermal oxidation are preferred, especially when gate dielectric 22 contains silicon dioxide. CVD techniques are employed in instances where the gate dielectric 22 contains one or more of silicon dioxide, silicon nitride, and silicon oxynitride.

The gate dielectric 22 later serves as the gate dielectric for subsequently formed high and/or low voltage transistors (not shown) in the periphery region 18. In one embodiment, the gate dielectric 22 has a thickness from about 30Å to about 300Å. In another embodiment, the gate dielectric 22 has a thickness from about 40Å to about 250Å. Before or after formation of gate dielectric 22, photoresist 20 is stripped or removed from the semiconductor structure 10.

Referring to Figure 4, another mask such as a suitable photoresist 24 is used to partially cover the charge trapping dielectric 14 in the core region 16 while covering the gate dielectric 22 in the periphery region 18 of the structure 10. In the core region 16, photoresist 24 is patterned such that there are openings 25 therein, The photoresist 24 is patterned in the core region 16 to facilitate/correspond to the formation of the buried bitlines (that is, areas of the charge trapping dielectric 14 directly over the subsequently formed buried bitlines are exposed by the patterned photoresist 24). Ions are implanted, as shown by the arrows, forming implanted region 26 directly below opening 25. The semiconductor structure 10 is optionally annealed at a suitable temperature after implantation.

One or more suitable implantation materials may be employed. The selection of implantation materials primarily depends on the type of substrate employed, for example, whether a p-type or n-type is used (p+, p-, n+, or n-). Examples of implantation materials include one or more of arsenic, boron, and phosphorus. In one embodiment, an n+ dopant is employed for implantation. In another embodiment, a p+ dopant is employed for implantation. Implantation is conducted to achieve a suitable dosage.

The implantation materials are implanted at a dosage suitable to form buried bitlines. In one embodiment, the implantation materials are implanted at a dosage from about 1 x 10¹⁴ to about 1 x 10¹⁶ atoms/cm². In another embodiment, the implantation materials are implanted at a dosage from about 5 x 10¹⁴ to about 7 x 10¹⁵ atoms/cm². In yet another embodiment, the implantation materials are implanted at a dosage from about 1 x 10¹⁵ to about 5 x 10¹⁵ atoms/cm².

Implanted regions 26, which correspond to the openings 25, form the buried bitlines in the resultant SONOS type nonvolatile memory device. The width of the implanted regions 26 at least substantially correspond to the width af the openings 25. In one embodiment, the width of the implanted regions 26 (and the subsequently formed bitlines) is from about 0.15µm to about 1.5µm. In another embodiment, the width of the implanted regions 26 (and the subsequently formed bitlines) is from about 0.18 µm to about 1 µm. In yet another embodiment, the width of the implanted regions 26 (and the subsequently formed bitlines) is from about 0.2 µm to about 0.75 µm.

Although not shown, a V_{T} adjustment implant step may optionally be conducted before or after the bitline implantation step. For example, the structure 10 may be tilted relative to the angle of implantation and implantation of boron may occur through openings 25 in the photoresist 24 in the core region 16 to form implanted regions (not shown) adjacent implanted regions 26. The V_{T} adjustment implant step typically employs a type dopant opposite that of the bitline implantation species.

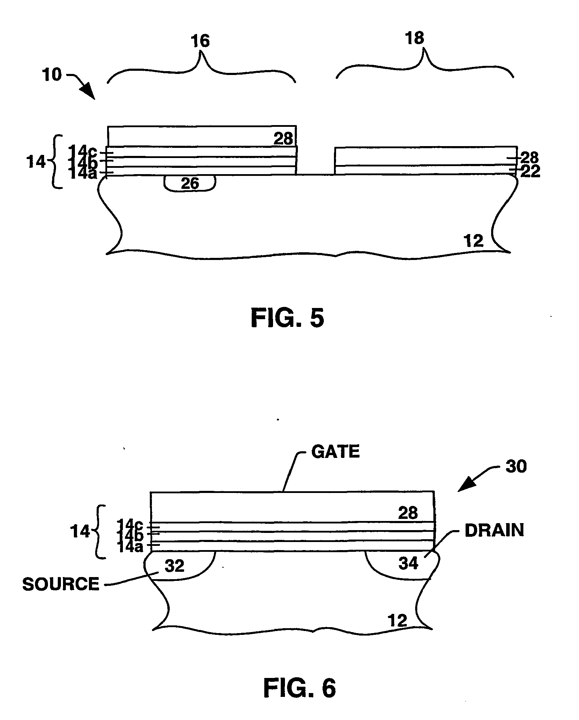

Referring to Figure 5, patterned photoresist 24 is removed from the structure 10, and polysilicon gates 28 are formed over the structure 10. In particular, after the photoresist 24 is stripped, polysilicon (or doped amorphous silicon) is deposited over the charge trapping dielectric 14 in the core region 16 and the gate dielectric 22 in the periphery region 18 by suitable techniques. In one embodiment, the polysilicon layer has a thickness (over the charge trapping dielectric 14) from about 500Å to about 6,000Å. In another embodiment, the polysilicon layer has a thickness from about 1,000Å to about 5,000Å. In yet another embodiment, the polysilicon layer has a thickness from about 1,500Å to about 4,000Å. The polysilicon layer is then patterned using suitable techniques to form polysilicon gates 28. For example, a photoresist (not shown) may be deposited and patterned using standard lithographic techniques covering a portion and exposing a portion of the polysilicon layer. The exposed portions of the polysilicon layer are removed by standard techniques, such as using anisotropic etching.

Although not shown, when the polysilicon gates 28 are formed over the structure 10, further processing is performed to complete the fabrication of SONOS type flash memory devices. For example, periphery source/drain regions and gates are doped, spacers are formed, salicidation, completion of formation of SONOS type flash memory cells, select gates, high voltage gates, and low voltage gates, and so on. The gates in the core region and the periphery region may be formed simultaneously or at different times. For example, gates may be initially formed in the core region and later formed in the periphery region or initially formed in the periphery region and later formed in the core region. Moreover, individual gates may be formed simultaneously or at different times within each of the periphery and core regions.

Referring to Figure 6, a SONOS type memory cell 30 formed in the core region of a SONOS type memory device is shown. The cell contains charge trapping dielectric 14, gate 28, source 32, and drain 34. SONOS type memory cell 30 can function and operate as a single bit cell or a double bit cell.

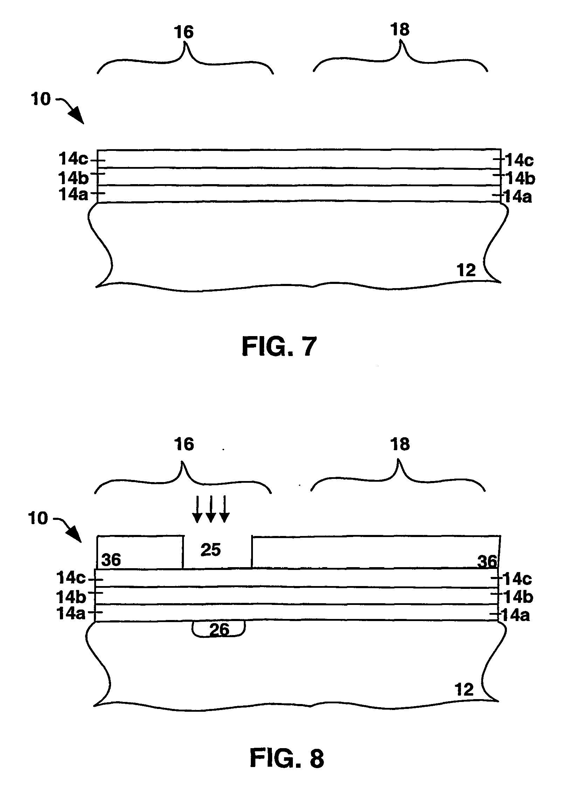

Another aspect of the present invention is described in Figures 7-12. Referring to Figure 7, a semiconductor structure 10 is shown with a semiconductor substrate 12 under a charge trapping dielectric 14. Semiconductor structure 10 contains two regions, the core region 16 containing the memory cells and the periphery region 18 containing the rest of the chip such as the controlling logic and input/output devices. As shown, the charge trapping dielectric 14 contains three layers; namely, a first silicon dioxide layer 14a, a silicon nitride layer 14b, and a second silicon dioxide layer 14c (an ONO dielectric). The charge trapping dielectric 14, may be any dielectric layer or layers that are capable of or facilitate electron trapping. Such dielectric layer or layers are discussed in connection with Figure 1, and not repeated here for brevity.

Although not shown, a threshold implant step may be conducted before formation of the charge trapping dielectric 14 over the structure. For example, a blanket implantation of boron may be performed just prior to forming the charge trapping dielectric 14. As explained below, this implantation step may be conducted before or after the bitline implantation step.

Referring to Figure 8, a mask such as a suitable photoresist 36 is used to partially cover the charge trapping dielectric 14 in the core region 16 while covering the charge trapping dielectric 14 in the periphery region 18 of the structure 10. In the core region 16, photoresist 36 is patterned such that there are openings 25 therein. The photoresist 36 is patterned in the core region 16 to facilitate/correspond to the formation of the buried bitlines (that is, areas of the charge trapping dielectric 14 directly over the subsequently formed buried bitlines are exposed by the patterned photoresist 36). Ions are implanted, as shown by the arrows, forming implanted region 26 directly below opening 25. The semiconductor structure 10 is optionally annealed at a suitable temperature after implantation.

One or more suitable implantation materials may be employed. The selection of implantation materials primarily depends on the type of substrate employed, for example, whether a p-type or n-type is used (p+, p-, n+, or n-). Examples of implantation materials include one or more of arsenic, boron, and phosphorus. The implantation materials are implanted at a dosage suitable to form buried bitlines, such as the dosages described in connection with Figure 4.

Implanted regions 26, which correspond to the openings 25, form the buried bitlines in the resultant SONOS type nonvolatile memory device. The width of the implanted regions 26 at least substantially correspond to the width of the openings 25.

Although not shown, a V_{T} adjustment implant step may optionally be conducted before or after the bitline implantation step. For example, the structure 10 may be tilted relative to the angle of implantation and implantation of boron may occur through openings 25 in the photoresist 36 in the core region 16 to form implanted regions (not shown) adjacent implanted regions 26. The V_{T} adjustment implant step typically employs a type dopant opposite that of the bitline implantation species.

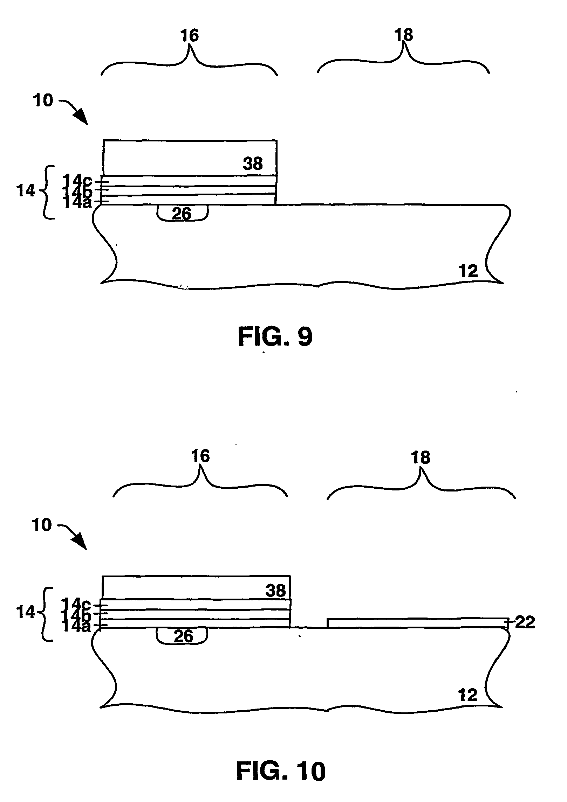

Referring to Figure 9, photoresist 36 is stripped or removed from the structure 10 and another mask such as a suitable photoresist 38 is used to cover the charge trapping dielectric 14 in the core region 16 leaving the charge trapping dielectric 14 exposed in the periphery region 18 of the structure 10. The charge trapping dielectric 14 exposed in the periphery region 18 is etched down to the substrate 12 (the first silicon dioxide layer 14a, the silicon nitride layer 14b, and the second silicon dioxide layer 14c are removed in the periphery region 18 of the structure 10). Multiple etching steps may be employed to remove the charge trapping dielectric 14.

Referring to Figure 10, a gate dielectric 22 such as an oxide layer is provided using any suitable means, such as CVD, dry oxidation, wet oxidation or rapid thermal oxidation, on at least a portion of the exposed portions of the substrate 12 (over the periphery region 18). Dry oxidation, wet oxidation, and rapid thermal oxidation are preferred, especially when gate dielectric 22 contains silicon dioxide. CVD techniques are employed in instances where the gate dielectric 22 contains one or more of silicon dioxide, silicon nitride, and silicon oxynitride.

The gate dielectric 22 later serves as the gate dielectric for subsequently formed high and/or low voltage transistors (not shown) in the periphery region 18. In one embodiment, the gate dielectric 22 has a thickness from about 30Å to about 300Å In another embodiment, the gate dielectric 22 has a thickness from about 40Å to about 250Å Before or after formation of gate dielectric 22, photoresist 38 is stripped or removed from the semiconductor structure 10.

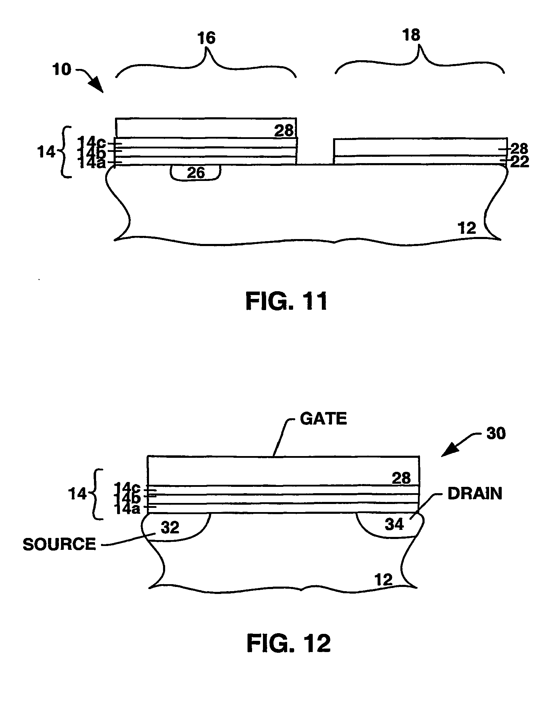

Referring to Figure 11, patterned photoresist 38 is removed from the structure 10, and polysilicon gates 28 are formed over the structure 10. In particular, after the photoresist 38 is stripped, polysilicon (or doped amorphous silicon) is deposited over the charge trapping dielectric 14 in the core region 16 and the gate dielectric 22 in the periphery region 18 by suitable techniques. The polysilicon layer is then patterned using suitable techniques to form polysilicon gates 28. For example, a photoresist (not shown) may be deposited and patterned using standard lithographic techniques covering a portion and exposing a portion of the polysilicon layer. The exposed portions of the polysilicon layer are removed by standard techniques, such as using anisotropic etching.

Although not shown, when the polysilicon gates 28 are formed over the structure 10, further processing is performed to complete the fabrication of SONOS type flash memory devices.

Referring to Figure 12, a SONOS type memory cell 30 formed in the core region of a SONOS type memory device is shown. The cell contains charge trapping dielectric 14, gate 28, source 32, and drain 34. SONOS type memory cell 30 can function and operate as a single bit cell or a double bit cell.

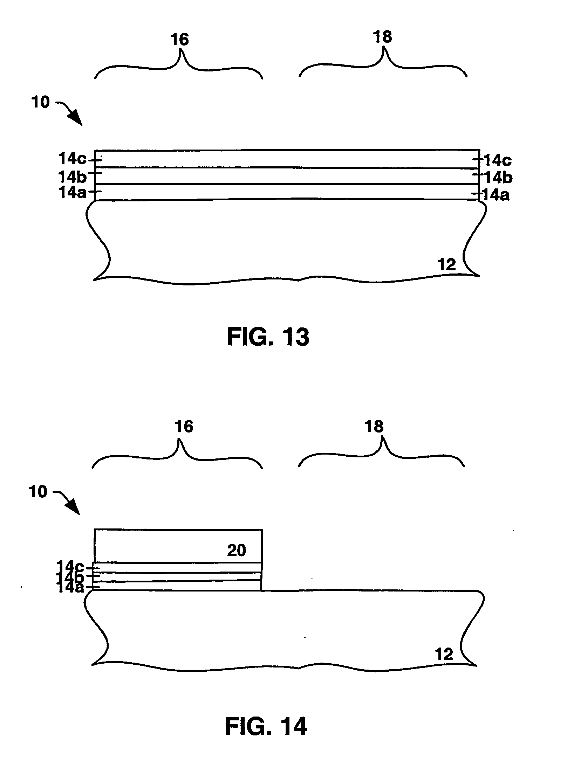

One aspect of the present invention is described in Figures 13-19. Referring to Figure 13, a semiconductor structure 10 is shown with a semiconductor substrate 12 under a charge trapping dielectric 14. Semiconductor structure 10 contains two regions, the core region 16 containing the memory cells and the periphery region 18 containing the rest of the chip such as the controlling logic and input/output devices. As shown, the charge trapping dielectric 14 contains three layers; namely, a first silicon dioxide layer 14a, a silicon nitride layer 14b, and a second silicon dioxide layer 14c (an ONO dielectric). The charge trapping dielectric 14, may be any dielectric layer or layers that are capable of or facilitate electron trapping. Such dielectric layer or layers are discussed in connection with Figure 1, and not repeated here for brevity.

Although not shown, a threshold implant step may be conducted before formation of the charge trapping dielectric 14 over the structure. For example, a blanket implantation of boron may be performed just prior to forming the charge trapping dielectric 14. As explained below, this implantation step may be conducted before or after the bitline implantation step.

Referring to Figure 14, a mask such as a suitable photoresist 20 is used to cover the charge trapping dielectric 14 in the core region 16 leaving the charge trapping dielectric 14 exposed in the periphery region 18 of the structure 10. The charge trapping dielectric 14 exposed in the periphery region 18 is etched down to the substrate 12 (the first silicon dioxide layer 14a, the silicon nitride layer 14b, and the second silicon dioxide layer 14c are removed in the periphery region 18 of the structure 10). Multiple etching steps may be employed to remove the charge trapping dielectric 14.

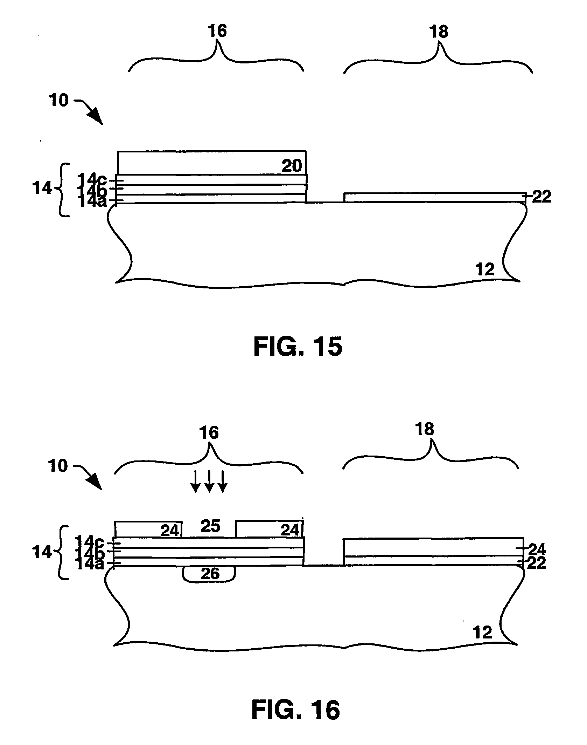

Referring to Figure 15, a gate dielectric 22 such as an oxide layer is provided using any suitable means, such as dry oxidation, wet oxidation, rapid thermal oxidation, or CVD, on at least a portion of the exposed portions of the substrate 12 (over the periphery region 18). Dry oxidation, wet oxidation, and rapid thermal oxidation are preferred, especially when gate dielectric 22 contains silicon dioxide. CVD techniques may be employed in instances where the gate dielectric 22 contains one or more of silicon dioxide, silicon nitride, and silicon oxynitride.

The gate dielectric 22 later serves as the gate dielectric for subsequently formed high and/or low voltage transistors (not shown) in the periphery region 18. In one embodiment, the gate dielectric 22 has a thickness from about 30Å to about 300Å. In another embodiment, the gate dielectric 22 has a thickness from about 40Å to about 250Å. Before or after formation of gate dielectric 22, photoresist 20 is stripped or removed from the semiconductor structure 10.

Referring to Figure 16, another mask such as a suitable photoresist 24 is used to partially cover the charge trapping dielectric 14 in the core region 16 while covering the gate dielectric 22 in the periphery region 18 of the structure 10. In the core region 16, photoresist 24 is patterned such that there are openings 25 therein. The photoresist 24 is patterned in the core region 16 to facilitate/correspond to the formation of the buried bitlines (that is, areas of the charge trapping dielectric 14 directly over the subsequently formed buried bitlines are exposed by the patterned photoresist 24). Ions are implanted, as shown by the arrows, forming implanted region 26 in the substrate 12 directly below opening 25. The semiconductor structure 10 is optionally annealed at a suitable temperature after implantation.

One or more suitable implantation materials may be employed. The selection of implantation materials primarily depends on the type of substrate employed, for example, whether a p-type or n-type is used (p+, p-, n+, or n-). Examples of implantation materials include one or more of arsenic, boron, and phosphorus. The implantation materials are implanted at a dosage suitable to form buried bitlines, such as the dosages described in connection with Figure 4.

Implanted regions 26, which correspond to the openings 25, form the buried bitlines in the resultant SONOS type nonvolatile memory device. The width of the implanted regions 26 at least substantially correspond to the width of the openings 25.

Although not shown, a V_{T} adjustment implant step may optionally be conducted before or after the bitline implantation step. For example, the structure 10 may be tilted relative to the angle of implantation and implantation of boron may occur through openings 25 in the photoresist 24 in the core region 16 to form implanted regions (not shown) adjacent implanted regions 26. The V_{T} adjustment implant step typically employs a type dopant opposite that of the bitline implantation species.

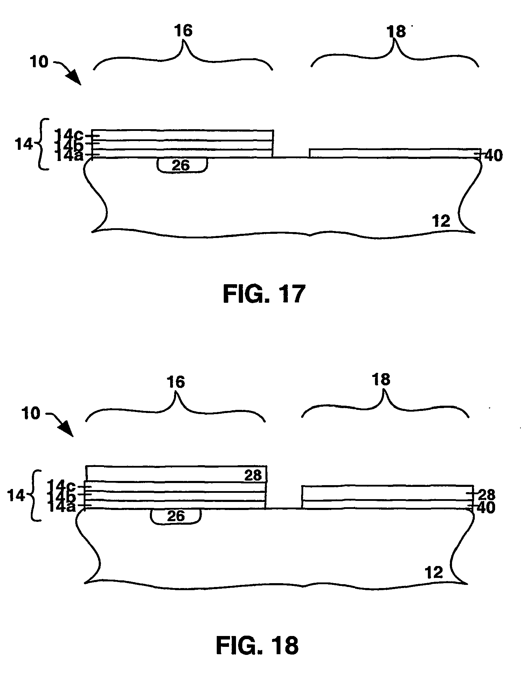

Referring to Figure 17, patterned photoresist 24 is removed from the structure 10, and additional gate dielectric material is formed in the periphery region 18 thereby providing a size enhanced (increased thickness) and/or cleaner gate dielectric 40. The additional gate dielectric material is preferably formed by thermal growth versus deposition, using any suitable means, such as dry oxidation, wet oxidation or rapid thermal oxidation, although CVD techniques may be employed. Dry oxidation, wet oxidation, and rapid thermal oxidation are preferred, especially when gate dielectric 40 contains silicon dioxide. In instances where the entire structure is subject to the oxidation treatment, the presence of the silicon nitride layer 14b substantially impedes the growth of oxide in the silicon dioxide layer 14c of the core region 16. CVD techniques are employed in instances where the gate dielectric 40 contains one or more of silicon dioxide, silicon nitride, and silicon oxynitride. In instances where CVD techniques are employed, it is preferable to mask the core region (not shown).

The growth or regrowth of additional periphery gate dielectric material serves to provide a cleaner gate dielectric over which to subsequently form gates and/or increase the thickness of the gate dielectrics in the periphery region 18. Forming the gate dielectrics 40 in two steps contributes to a reduction in unwanted diffusion of the bitline implants. In one embodiment, the size enhanced gate dielectric 40 has a thickness from about 80Å to about 350Å. In another embodiment, the size enhanced gate dielectric 40 has a thickness from about 40Å to about 300Å. In yet another embodiment, the size enhanced gate dielectric 40 has a thickness that is at least about 10% larger than the thickness of gate dielectric 22.

Although not shown, in some instances, a portion of the gate dielectric 22 in the periphery region 18 may be removed (using, for example, lithographic techniques) leaving the periphery region 18 partially covered by the gate dielectric 22 when the growth or regrowth of additional periphery gate dielectric material is conducted. In these instances, the remaining portion of the gate dielectric 22 is formed into the size enhanced gate dielectric, while fresh gate dielectric is formed in the portions where the gate dielectric 22 is previously removed. This is advantageous _ when different subsequently formed gates in the periphery region 18 require gate dielectrics of different thickness. For instance, high voltage gate transistors may require thicker gate oxides than low voltage gate transistors. In these instances, the size enhanced gate dielectric 40 may have two or more thicknesses. The growth or regrowth of additional periphery gate dielectric material is therefore conducted in one or more steps, two or more steps, etc.

Referring to Figure 18, polysilicon gates 28 are formed over the structure 10. In particular, polysilicon (or doped amorphous silicon) is deposited over the charge trapping dielectric 14 in the core region 16 and the size enhanced gate dielectric 40 (increased thickness) in the periphery region 18 by suitable techniques. The polysilicon layer is then patterned using suitable techniques to form polysilicon gates 28. For example, a photoresist (not shown) may be deposited and patterned using standard lithographic techniques covering a portion and exposing a portion of the polysilicon layer. The exposed portions of the polysilicon layer are removed by standard techniques, such as using anisotropic etching.

Although not shown, when the polysilicon gates 28 are formed over the structure 10, further processing is performed to complete the fabrication of SONOS type flash memory devices.

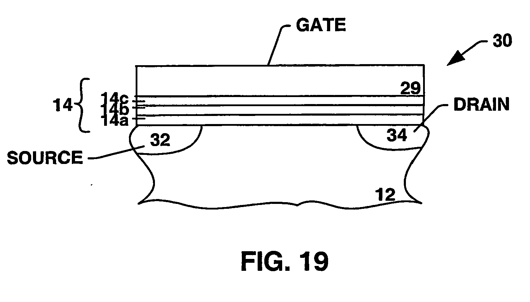

Referring to Figure 19, a SONOS type memory cell 30 formed in the core region of a SONOS type memory device is shown. The cell contains charge trapping dielectric 14, gate 29, source 32, and drain 34. SONOS type memory cell 30 can function and operate as a single bit cell or a double bit cell.

Referring to Figure 20, a perspective illustration of the core region of a SONOS type memory device is shown. The structure is substantially planar and contains a substrate 12, charge trapping dielectric 14, polysilicon gates/wordlines 28, and buried bitlines 26. In particular, the polysilicon gates/wordlines 28 have a planar or substantially planar orientation while having a substantially uniform thickness. The charge trapping dielectric 14 contains three layers 14a, 14b, and 14c, such as an ONO dielectric, an oxide/tantalum oxide/oxide dielectric, an oxide/strontium titanate/oxide dielectric, an oxide/strontium titanate/barium strontium titanate dielectric, or an oxide/hafnium oxide/oxide dielectric. The dashed lines show the extension of the buried bitlines 26 through substrate 12.

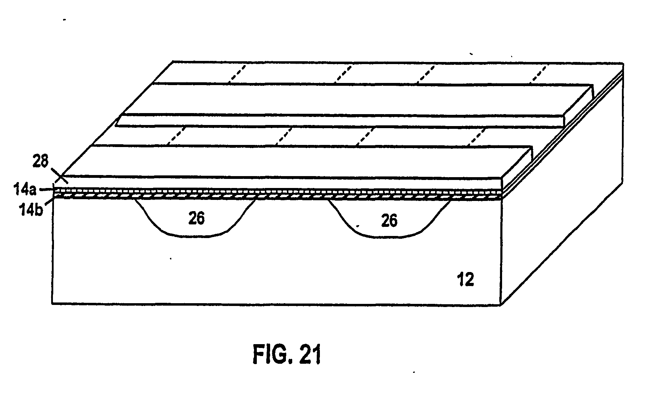

Referring to Figure 21, a perspective illustration of the core region of another SONOS type memory device is shown. The structure is substantially planar and contains a substrate 12, charge trapping dielectric 14, polysilicon gates/wordlines 28, and buried bitlines 26. In particular, the polysilicon gates/wordlines 28 have a planar or substantially planar orientation while having a substantially uniform thickness. The charge trapping dielectric 14 contains two layers 14 a and 14b, such as an oxide/nitride dielectric, a nitride/oxide dielectric, an oxide/tantalum oxide dielectric, an oxide/strontium titanate dielectric, or an oxide/barium strontium titanate dielectric. The dashed lines show the extension of the buried bitlines 26 through substrate 12.

Referring to Figure 22, a portion of the core region of a prior art SONOS type memory devices according to Mitchell et al U.S. Patent 5,168,334 is shown. Figure 22 is analogous to Figure 5 of Mitchell et al U.S. Patent 5,168,334. Figure 22 shows silicon substrate 42 having field oxide regions 43, bitlines 44 and 46, ONO trilayer 50/52/54, and polysilicon wordline 56. The structure of prior art Figure 22 is non-planar, due to the presence of oxide regions 43. Consequently, the polysilicon wordline 56 is non-planar.

Severe topology in many instances restricts the use of metals and other materials in connections to elements of the memory device since deposition of metals and other materials over severe topology is not fully reliable and may cause opens due to metal migration. Depositing a conformal film over severe topography gives thickness variations which make it difficult, in many instances, to etch the deposited film completely without overetching the underlying layer in the planar portions of the substrate (stringer formation). Further, when oxide isolation such as LOCOS is used, the resulting non-planar surface presents potential problems with exposure resolution during lithographic patterning. This is primarily due to limitations on the defocus window (e.g. depth of field). Such limitations are especially severe in high numerical aperture tools used for high speed exposure. As a result, these limitations can easily cause a reduction of throughput and/or a reduction of manufacturing yield. Reductions in throughput and/or manufacturing yield tend to increase costs of memory devices. The oxidation associated with LOCOS formation undesirably causes boron segregation (undesirable migration of implanted boron into oxide) and undesirably affects the arsenic dopant profile (oxidation enhanced diffusion).

The planar orientation of the core regions, such as those described in Figures 20 and 21, contributes to a number of advantages for the non-volatile semiconductor memory devices of the present invention. For example, planar non-volatile semiconductor memory devices do not require an etch step for making the bitlines, thus, the process of fabricating such devices is simplified. The fabrication of planar non-volatile semiconductor memory devices provides a controllable junction (improved diffusion control). That is, boron segregation is minimized and/or eliminated and the final arsenic dopant profile is not effected by oxidation enhanced diffusion. The less severe topography (increased planarity) enables improved linewidth control (and generally improved lithographic manipulations) compared to memory devices having non-planar orientations. The less severe topography minimizes and/or eliminates stringer formation. The less severe topography also results in better yields compared to memory devices having non-planar orientations. Moreover, it is easier to provide structures/elements over a planar surface than a non-planar surface. Finally, handling and packaging planar non-volatile semiconductor memory devices is easier and more efficient than non-planar memory devices.

Typically when a semiconductor device is scaled, the channel lengths become shorter and short channel effects take hold. Thus, in the case of two bit memory cell, because each bit is stored in different areas of the transistor, short channel effects may become prevalent sooner than in the case of the single bit transistor. However, in the SONOS type memory devices of the present invention, short channeling effects are minimized, since there is no LOCOS in the core region.

Various methods of using the substantially planar non-volatile semiconductor memory devices of the present invention are described hereinafter. However, it is understood that these methods are merely exemplary as other methods exist and/or may be developed. One or two bit operations may be employed when using the substantially planar non-volatile semiconductor memory devices of the present invention.

Referring to Figure 19 again, if the SONOS type memory cell 30 is read by reading in the same direction as programming, the time needed to program the device increases. Reading in the same direction as programming means the device is programmed and read in the same forward direction. During a read, voltages having levels lower than that during programming are applied to the gate and drain and the channel current is sensed. However, a dramatic reduction in programing time is achieved due to amplification of the effect of the trapped charge infected into the nitride layer brought about by reading the memory cell device in the opposite direction from which it was programmed.

Although not wishing to be bound by any theory, it is believed that during programming, hot electrons are injected into the nitride layer 14b. Since the nitride 14b is a nonconductor, the trapped charge remains localized to the region of the nitride layer near the drain 34. If the cell 30 is now read in the conventional forward direction (i.e., voltages are applied to the gate 28 and drain 34), electrons move off the source 32 and begin traveling toward the drain 34.

When the cell 30 is read in the forward direction a voltage is applied to the drain 34 and the gate 28, and the source 32 is grounded or at a lower voltage. Reading in the backward direction means reading in a direction opposite than that of programming. In other words, voltage is applied to the source 32 and the gate 28 and the drain 34 is grounded or at a lower voltage.

In programming the two bit cell of the present invention, each bit, i.e., the left and right bit, is treated as if the cell 30 is a single bit cell. In other words, both the left and right bits are programmed as previously described. For the right bit, for example, programming voltages are applied to the gate 28 and drain 34 and hot electrons are injected into and trapped in the charge trapping layer 14b in the region near the drain 34. The left bit is programmed by applying programming voltages to the gate 28 and source 32, which now functions as the drain for the left bit.

When programming one bit when the other has not been programmed (for example, if the right bit is programmed), the threshold voltage for a programmed left bit is relatively low compared to the threshold voltage for the right bit and thus the state of the right bit can be read without interference from the left bit. During programming of the right bit, the unprogrammed left bit remains unprogrammed.

When programming one of the bits when the other bit has been previously programmed (for example, if during a first pass the right bit is programmed while reading the unprogrammed left bit, and during a second pass the left bit is programmed), the gate voltage during programming is sufficiently high that the programmed right bit does not substantially interfere with the programming of the left bit. During the first pass, the left bit remains unprogrammed during the programming of the right bit. During the second pass, the left bit is programmed and the right bit remains programmed and can still be read. The right bit can be programmed through during programming of the left bit. Further, the programming of the left bit does not disturb the programmed right bit.

In reading the two bit cell, each bit is treated as if the cell 30 is a single bit cell. The right bit is read in the reverse direction by applying read voltages to the source 32 and the gate 28 and grounding or applying a lower voltage to the drain 34. Similarly, to read the left bit in the reverse direction, read voltages are applied to the gate 28 and to the drain 34 and the source 32 is grounded or at a lower voltage. A read of the two bit memory device of the present invention falls into one of three cases: (1) neither of the two bits are programmed (2) one of the bits is programmed and the other is not or (3) both of the bits are programmed.

Again although not wishing to be bound by any theory, it is believed that the mechanism used to erase the two bit flash memory cell of the present invention involves the movement of holes or the movement of electrons. In instances where erase involves the movement of holes, erase involves tunnelling enhanced hot hole injection through the bottom oxide 14a. Hole flow is generated by band to band tunneling in a deep depletion layer under the charge trapping layer 14 above a junction. Holes increase their energy due to the lateral field and they are injected through the bottom oxide 14a of the charge trapping layer 14, where they recombine with the electrons or are trapped. In these instances erase is typically performed by simultaneously applying a positive potential to the source 32 or the drain 34 and zero potential, i.e., ground, or lower voltage potential to the gate 28. Alternatively, erase is performed by simultaneously applying a positive potential to the source 32 or the drain 34 and negative potential to the gate 28.

In instances where erase involves the movement of electrons, for the right bit, an erase is performed by removing electrons from the charge trapping nitride region either through the gate 28 via the top oxide 14c or through the drain 34 via the bottom oxide 14a. For the left bit, an erase is performed by removing electrons from the charge trapping nitride region either through the gate 28 via the top oxide 14c or through the source 32 via the bottom oxide 14a. Erasing of one of the bits does not affect the other bit because the erase voltage is localized to the junction adjacent to the bit that is to be erased.

Using the right bit as an example, one technique of erasing is to simultaneously apply a negative potential to the gate 28 and a positive potential to the drain 34 such that electron tunneling occurs from the charge trapping nitride layer 14b to the drain 34 via the bottom oxide 14a. The left bit is erased in a similar fashion except that a positive potential is applied to the source 32 rather than the drain 34.

Using the right bit as an example, a second technique is to simultaneously apply a positive voltage potential to the gate 28 and zero potential, i.e., ground, or lower voltage potential to the drain 34 such that electron tunneling occurs from the charge trapping nitride layer 14b through the top oxide 14c to the gate 28. The right bit is erased in a similar fashion with zero potential or lower voltage potential applied to the source 32.

Although the invention has been shown and described with respect to certain embodiments, it is obvious that equivalent alterations and modifications will occur to others skilled in the art upon the reading and understanding of this specification and the annexed drawings. In particular regard to the various functions performed by the above described features, the terms used to describe such features are intended to correspond, unless otherwise indicated, to any element which performs the specified function of the described feature (i.e., that is functionally equivalent), even though not structurally equivalent to the disclosed structure which performs the function in the herein illustrated exemplary embodiments of the invention. In addition, while a particular feature of the invention may have been disclosed with respect to only one of several embodiments, such feature may be combined with one or more other features of the other embodiments as may be desired and advantageous for any given or particular application.

### INDUSTRIAL APPLICABILITY

The devices of the present invention are useful in the field of non-volatile semiconductor memory device. Particularly, the devices of the present invention are useful in non-volatile flash memory devices, such as EEPROMs.

## Claims

1. A non-volatile SONOS semiconductor memory device, comprising:
a substrate (12), the substrate having a core region and a periphery region;
a gate dielectric in the periphery region of the substrate;
wordlines over the charge trapping dielectric in the core region;
the device being **characterized in that** it comprises a charge trapping dielectric (14) over the entire core region of the substrate, wherein the core region is substantially planar, wherein substantially planar means that the surface height does not vary by more than 25 nm;
and buried bitlines (26) directly under the charge trapping dielectric in the core region.

2. The memory device according to claim 1, wherein the charge trapping dielectric (14) comprises at least one of an ONO trilayer dielectric, an oxide/nitride bilayer dielectric, a nitride/oxide bilayer dielectric, an oxide/tantalum oxide bilayer dielectric, an oxide/tantalum oxide/oxide trilayer dielectric, an oxide/strontium titanate bilayer dielectric, an oxide/barium strontium titanate bilayer dielectric, an oxide/strontium titanate/oxide trilayer dielectric, an oxide/strontium titanate/barium strontium titanate trilayer dielectric, and an oxide/hafnium oxide/oxide trilayer dielectric.

3. The memory device according to claim 1, wherein the charge trapping dielectric (14) comprises an ONO dielectric comprising at least one of a nitrided oxide layer and a silicon-rich silicon nitride layer.

4. The memory device according to claim 1 wherein:
the charge trapping dielectric is an ONO charge trapping dielectric (14); and
the wordlines are substantially planar wordlines (28) having a substantially uniform thickness over the ONO charge trapping dielectric in the core region.

5. The memory device according to claim 4, wherein the ONO charge trapping dielectric (14) comprises at least one of a nitrided oxide layer and a silicon-rich silicon nitride layer.

## Patentansprüche

1. Nichtflüchtige SONOS-Halbleiterspeichervorrichtung mit:
einem Substrat (12), wobei das Substrat einen Kernbereich und einen Peripheriebereich aufweist;
einem Gate-Dielektrikum in dem Peripheriebereich des Substrats;
Wortleitungen über dem Ladungseinfang-Dielektrikum in dem Kernbereich;
wobei die Vorrichtung **dadurch gekennzeichnet ist, dass** sie aufweist:
ein Ladungseinfang-Dielektrikum (14) über dem gesamten Kernbereich des Substrats, wobei der Kernbereich im Wesentlichen planar ist, wobei im Wesentlichen planar bedeutet, dass die Oberflächenhöhe um nicht mehr als 25 nm variiert;
und vergrabene Bitleitungen (26) direkt unter dem Ladungseinfang-Dielektrikum in dem Kernbereich.

2. Speichervorrichtung nach Anspruch 1, bei der das Ladungseinfang-Dielektrikum (14) mindestens eines der folgenden Elemente aufweist: ein ONO-Dreischichten-Dielektrikum, ein Oxid/Nitrid-Zweischichten-Dielektrikum, ein Nitrid/Oxid-Zweischichten-Dielektrikum, ein Oxid/Tantaloxid-Zweischichten-Dielektrikum, ein Oxid/Tantaloxid-/Oxid-Dreischichten-Dielektrikum, ein Oxid-Stontiumtitanat-Zweischichten-Dielektrikum, ein Oxid-Barium-/Stontium-Titanat-Zweischichten-Dielektrikum, ein Oxid-Stontiumtitanat-/Oxid-Dreischichten-Dielektrikum, ein Oxid-Stontiumtitanat-/Bariumstrontium-Titanat-Dreischichten-Dielektrikum, und ein Oxid-/Hafniumoxid-/Oxid-Dreischichten-Dielektrikum.

3. Speichervorrichtung nach Anspruch 1, bei der das Ladungseinfang-Dielektrikum (14) ein ONO-Dielektrikum mit mindestens einer Schicht aufweist, die aus einer nitrierten Oxidschicht und einer siliciumreichen Siliciumnitridschicht gewählt ist.

4. Speichervorrichtung nach Anspruch 1, bei der:
das Ladungseinfang-Dielektrikum ein ONO-Ladungseinfang-Dielektrikum (14) ist; und
die Wortleitungen im Wesentlichen planare Wortleitungen (28) sind, die eine Wesentlichen gleichförmige Dicke über dem ONO-Ladungseinfang-Dielektrikum in dem Kernbereich haben.

5. Speichervorrichtung nach Anspruch 4, bei der das ONO-Ladungseinfang-Dielektrikum (14) mindestens eine Schicht aufweist, die aus einer nitrierten Oxidschicht und einer siliciumreichen Siliciumnitridschicht gewählt ist.

## Revendications

1. Dispositif de mémoire non volatile SONOS à semiconducteur comprenant :
un substrat (12), le substrat comportant une zone de coeur et une zone périphérique ;
un diélectrique de grille dans la zone périphérique du substrat ;
des lignes de mot sur le diélectrique de piégeage de charges dans la zone de coeur ;
le dispositif étant **caractérisé en ce qu'**il comprend un diélectrique de piégeage de charges (14) situé sur la zone de coeur tout entière du substrat, dans lequel la zone de coeur est essentiellement plane, dans lequel des moyens essentiellement planaires dont le niveau de surface ne varie pas de plus de 25 nm ;
et des lignes de binaires enterrées (26) situées directement sous le diélectrique de piégeage de charges dans la zone de coeur.

2. Dispositif de mémoire selon la revendication 1, dans lequel le diélectrique de piégeage de charges (14) comprend au moins l'un d'un diélectrique à trois couches ONO, d'un diélectrique à deux couches d'oxyde/nitrure, d'un diélectrique à deux couches de nitrure/oxyde, d'un diélectrique à deux couches d'oxyde / oxyde de tantale, d'un diélectrique à trois couches d'oxyde/ oxyde tantale/oxyde, d'un diélectrique à deux couches d'oxyde/ titanate de strontium, d'un diélectrique à deux couches d'oxyde/titanate de baryum strontium, d'un diélectrique à trois couches d'oxyde/titanate de strontium/oxyde, d'un diélectrique à trois couches d'oxyde/ titanate de strontium/ titanate de baryum strontium, et d'un diélectrique à trois couches d'oxyde / oxyde d'hafnium / oxyde.

3. Dispositif de mémoire selon la revendication 1, dans lequel le diélectrique de piégeage de charges (14) comprend un diélectrique ONO comportant au moins l'une d'une couche d'oxyde nitrurée et d'une couche de nitrure de silicium riche en silicium.

4. Dispositif de mémoire selon la revendication 1, dans lequel :
le diélectrique de piégeage de charges est un diélectrique de piégeage de charges ONO (14) ; et
les lignes de mot sont essentiellement des lignes de mot planaires (28) présentant une épaisseur essentiellement uniforme sur le diélectrique de piégeage de charges ONO dans la zone de coeur.

5. Dispositif de mémoire selon la revendication 4, dans lequel le diélectrique de piégeage de charges ONO (14) comporte au moins l'une d'une couche d'oxyde nitrurée et d'une couche de nitrure de silicium riche en silicium.
